# EUROPÄISCHE PATENTSCHRIFT

(11) **EP 4 211 748 B1**
(45) Veröffentlichungstag und Bekanntmachung des Hinweises auf die Patenterteilung: **09.07.2025**
(21) Anmeldenummer: 21769052.8
(22) Anmeldetag: 16.08.2021
(51) Int. Cl.: H01Q 1/22, H01P 5/107, H01Q 1/32, G01S 7/03, H01Q 21/00, H01Q 21/06, H01Q 1/02, G01S 13/42, G01S 13/931

(54) **RADARSYSTEM ZUR UMGEBUNGSERFASSUNG MIT EINER WELLENLEITERANTENNE GEBILDET AUS EINER PLATINE UND EINEM FORMTEIL**
RADAR SYSTEM FOR DETECTING SURROUNDINGS, COMPRISING A WAVEGUIDE ANTENNA MADE OF A PRINTED CIRCUIT BOARD AND A MOLDED PART
SYSTÈME RADAR SERVANT À DÉTECTER UN ENVIRONNEMENT, COMPRENANT UNE ANTENNE À GUIDE D'ONDES CONSTITUÉE D'UNE CARTE DE CIRCUIT IMPRIMÉ ET D'UNE PIÈCE MOULÉE

(30) Priorität: 08.09.2020 DE 102020211254
(43) Veröffentlichungstag der Anmeldung: 19.07.2023
(73) Patentinhaber: Continental Autonomous Mobility Germany GmbH, 85057 Ingolstadt (DE)
(72) Erfinder: WINTERMANTEL, Markus, 90411 Nürnberg (DE)
(74) Vertreter: Continental Corporation
(86) Internationale Anmeldenummer: PCT/DE2021/200111
(87) Internationale Veröffentlichungsnummer: WO 2022/053114

(56) Entgegenhaltungen:
- WO-A1-2018/001921
- DE-A1- 102018 203 106
- DE-B3- 102018 213 540
- US-A1- 2009 243 948
- US-A1- 2020 251 430

## Beschreibung

Die Erfindung bezieht sich auf ein Radarsystem zur Umgebungserfassung für Kraftfahrzeuganwendungen. Das Radarsystem besitzt erfindungsgemäß eine Wellenleiterantenne sowie ein Hochfrequenzbauteil mit mindestens einem Element zum direkten Abstrahlen bzw. Empfangen, wobei sich Wellenleiterantenne und Hochfrequenzbauteil auf entgegengesetzten Seiten der Platine befinden und die Wellenleiterantenne aus der Platine und einem Formteil gebildet ist.

### Stand der Technik

Kraftfahrzeuge werden zunehmend mit Fahrerassistenzsystemen ausgerüstet, welche mit Hilfe von Sensorsystemen die Umgebung erfassen und aus der so erkannten Verkehrssituation automatische Reaktionen des Fahrzeugs ableiten und/oder den Fahrer instruieren, insbesondere warnen. Dabei unterscheidet man zwischen Komfort- und Sicherheitsfunktionen.

Als Komfortfunktion spielt in der momentanen Entwicklung FSRA (Full Speed Range Adaptive Cruise Control) eine wichtige Rolle. Das Fahrzeug regelt dabei die Eigengeschwindigkeit auf die vom Fahrer vorgegebene Wunschgeschwindigkeit ein, sofern die Verkehrssituation dies zulässt, andernfalls wird die Eigengeschwindigkeit automatisch an die Verkehrssituation angepasst.

Sicherheitsfunktionen gibt es mittlerweile in vielfältiger Ausprägung. Eine Gruppe bilden dabei Funktionen zur Reduzierung des Brems- bzw. Anhalteweges in Notsituationen bis hin zur autonomen Notbremsung. Eine weitere Gruppe sind Spurwechselfunktionen: Sie warnen den Fahrer bzw. greifen in die Lenkung ein, wenn der Fahrer einen gefährlichen Spurwechsel durchführen möchte, also wenn sich ein Fahrzeug auf der Nebenspur entweder im toten Winkel befindet (wird als BSD - "Blind Spot Detection" - bezeichnet) oder sich schnell von hinten nähert (LCA - "Lane Change Assist").

In absehbarer Zukunft wird der Fahrer aber nicht mehr nur assistiert, sondern die Aufgabe des Fahrers wird zunehmend autonom vom Fahrzeug erledigt, d. h. der Fahrer wird zunehmend ersetzt; man spricht von autonomem Fahren.

Für Systeme der oben beschriebenen Art werden Radarsensoren eingesetzt, häufig auch in Fusion mit Sensoren anderer Technologie, wie z.B. Kamerasensoren. Radarsensoren haben u. a. den Vorteil, dass sie auch bei schlechten Wetterbedingungen zuverlässig arbeiten und neben dem Abstand von Objekten auch direkt deren radiale Relativgeschwindigkeit über den Dopplereffekt messen können. Als Sendefrequenzen werden dabei in der Regel 24GHz, 77GHz und 79GHz eingesetzt.

Durch den zunehmenden funktionalen Umfang solcher Systeme erhöhen sich permanent die Anforderungen, insbesondere an die maximale Detektionsreichweite. Gleichzeitig findet aber dennoch ein starker Preisverfall statt.

Neben der Umfelderfassung von Kraftfahrzeugen für Systeme der oben beschriebenen Art rückt mittlerweile auch die Innenraumüberwachung von Kraftfahrzeugen in den Fokus, z. B. zur Erkennung, welche Sitze belegt sind; dabei werden Frequenzen im Bereich 60GHz eingesetzt. Die dafür verwendeten Radarsensoren müssen in besonderem Maße kostengünstig sein, um mit anderen Technologien zur Innenraumüberwachung konkurrieren zu können.

Ein zentrales Element jedes Radarsensors ist die Antenne; sie definiert maßgeblich die Performance und den Preis des Sensors. Aktuell werden die Antennen meist in Planartechnologie auf der Hochfrequenz-Platine realisiert, z. B. als Patchantennen. Nachteilig an einer solchen Antennenrealisierung sind einerseits die Verluste in Zuleitungen und Antennen selber (was die Reichweite limitiert) und andererseits die hohen Kosten für eine solche Platine (insbesondere weil spezielle hochfrequenzfähige Substrate benötigt werden, die teuer sind und eine aufwändige Prozessierung benötigen).

Aus DE 102018203106 A1 ist ein grundsätzlicher Aufbau eines gattungsgemäßen Radarsensors bekannt, welcher die Nachteile der Planartechnologie dadurch überwindet, dass eine Wellenleiterantenne aus Kunststoff und ein Hochfrequenzbauteil mit mindestens einem Element zum direkten Abstrahlen bzw. Empfangen eingesetzt wird, wobei sich Wellenleiterantenne und Hochfrequenzbauteil auf entgegengesetzten Seiten des Platine befinden und die Kopplung zwischen Hochfrequenzbauteil und Wellenleiterantenne durch die Platine hindurch erfolgt, z. B. über ein einfaches Loch in der Platine. In DE 102018203106 A1 ist nicht beschrieben, wie die Wellenleiterantenne und die PCB einfach und robust miteinander verbunden werden können. Außerdem weist die dort beispielhaft gezeigte Antenne innenliegende Hohlleiterkanäle auf, d. h. sie muss aus wenigstens zwei Lagen zusammengesetzt sein.

Ferner beschreibt US 2020/251430 A1 ein Halbleiterbauelement, umfassend ein Substrat mit einer ersten Oberfläche und einer zweiten Fläche gegenüber der ersten Oberfläche, mindestens einem Verbindungselement, das auf der ersten Oberfläche des Substrats angeordnet ist, um das Substrat elektrisch und mechanisch mit einer Leiterplatte zu verbinden, und einen Radarhalbleiterchip, der auf der ersten Oberfläche des Substrats angeordnet ist.

WO 2018/001921 A1 offenbart eine Antenne, die Antenne eine Antennenoberseite und eine Antennenunterseite und eine Wellenleiterkanalstruktur mit einer Vielzahl von Wellenleiterendzweigen aufweist. Jeder Hohlleiter-Endzweig mündet dabei in eine zugeordnete Hohlleiteröffnung in der Antennenoberseite, wobei die Hohlleiter-Öffnungen in einem Muster von Zeilen und Spalten angeordnet sind.

Darüber hinaus beschreibt US 2009/243948 A1 eine modulare Einheit für ein Radarantennen-Array mit integriertem HF-Chip, mindestens einem Antennenelement, das eine Mikrowellenstruktur aufweist, einem Fokussierelement, das im Strahlengang des Radarantennen-Arrays vor dem mindestens einen Antennenelement angeordnet ist, mit dem eine verstärkte Ausleuchtung des HF-Chips erreicht wird.

### Aufgabe, Lösung und Vorteile der Erfindung

Aufgabe der Erfindung ist es, ausgehend vom Stand der Technik (z. B. für das generelle Konzept aus DE 102018203106 A1) einen einfachen, robusten und kostengünstig zu realisierenden Aufbau vorzuschlagen.

Diese Aufgabe wird grundsätzlich durch ein Radarsystem gemäß Anspruch 1 gelöst. Zweckmäßige Ausgestaltungen der Erfindung sind in den Unteransprüchen beansprucht.

Die Vorteile der Erfindung ergeben sich aus der Tatsache, dass ein Radarsystem mit verbesserter Performance, geringerem Preis und reduzierter Größe robust und einfach realisiert werden kann.

Das erfindungsgemäße Radarsystem zur Umgebungserfassung weist folgendes auf:
- eine Platine, welche mindestens ein Hochfrequenzbauteil mit mindestens einem Element zum direkten Abstrahlen bzw. Empfangen trägt, und
- ein Formteil, welches an seiner Oberseite eine oder mehrere Einzelantennen zum Senden und/oder Empfangen von Radarsignalen aufweist,
- wobei die Verbindung zwischen dem mindestens einen abstrahlenden bzw. empfangenden Element des Hochfrequenzbauteils und der mindestens einen Einzelantenne auf der Oberseite des Formteils zumindest teilweise durch innenliegende Wellenleiter realisiert wird,
- das mindestens eine abstrahlende bzw. empfangende Element des Hochfrequenzbauteils derart ausgebildet ist, dass es in Richtung Platine abstrahlt bzw. aus Richtung Platine empfängt,
- die Platine im Bereich des mindestens einen abstrahlenden bzw. empfangenden Elements für Radarwellen durchlässig ist,
- das Formteil auf der zu dem wenigstens einen Hochfrequenzbauteil gegenüberliegenden Seite der Platine angeordnet und mit dieser insbesondere durch Lötung und/oder leitfähige Verklebung zumindest partiell und leitfähig verbunden ist,
- wenigstens ein hohlförmiger Wellenleiter durch eine Vertiefung auf der der Platine zugewandten Seite des Formteils und eine metallisierte Oberfläche von der zu dem wenigstens einen Hochfrequenzbauteil gegenüberliegenden Seite der Platine gebildet wird,
- dieser wenigstens eine Wellenleiter aus einer durchlässigen Stelle der Platine gespeist wird und
- durch diesen Aufbau das Formteil aus einem einlagigen zumindest partiell metallisierten Kunststoffteil bestehen kann bzw. besteht.

Zweckmäßigerweise können Formteil und Platine bereits während des Prozesses der Lötung (Lötprozess) und/oder der Verklebung (Klebeprozess) zusammengepresst werden.

Das Zusammenpressen wird dabei vorzugsweise durch temporär angebrachte Federelemente wie z. B. Klammern und/oder Federstifte realisiert.

Alternativ kann das Zusammenpressen auch durch in das Formteil integrierte federnde Elemente realisiert werden, welche mit der Platine vorzugsweise durch Einpressen oder Clipsen verbunden sind.

Ferner kann das Formteil Sollbiegestellen aufweisen, durch die es an die Platine angeordnet oder angepresst wird.

Vorzugsweise sind auf der der Platine zugewandten Seite des Formteils Lotperlen angeordnet, die zur Verlötung dienen und Teil der Wellenleiterberandung sind.

Zweckmäßigerweise kann die Positionierung des Formteils parallel zur Platine durch Strukturen, wie beispielweise Zapfen und Stifte, realisiert werden, die vom Formteil in Aussparungen oder Löcher der Platine ragen.

Gemäß einer bevorzugten Ausgestaltung der Erfindung ist die mindestens eine für Radarwellen durchlässige Stelle der Platine durch ein Loch in der Platine mit metallisierten Seitenwänden ausgebildet.

Die mindestens eine für Radarwellen durchlässige Stelle in der Platine kann dadurch realisiert sein, dass sich dort auf und/oder zwischen Trägermaterialschichten der Platine keine Metallisierung befindet und die Stelle mit Durchkontaktierungen umrandet bzw. von diesen umgeben ist.

Vorzugsweise sind auf der Unterseite des mindestens einen Hochfrequenzbauteils Lotperlen um das mindestens eine abstrahlende bzw. empfangende Element derart angeordnet, dass ein seitliches Entweichen der Strahlung in einem Zwischenraum von Hochfrequenzbauteil und Platine reduziert bzw. verhindert wird, insbesondere um eine Verkopplung zwischen mehreren Übergängen zu vermeiden.

Zweckmäßigerweise kann das Radarsystem eine thermisch gut leitende Komponente umfassen, insbesondere einen Deckel, beispielsweise aus Metall, wobei die Komponente auf derselben Seite der Platine wie das mindestens eine Hochfrequenzbauteil angeordnet ist. Zudem kann ein thermischer Kontakt, insbesondere durch Wärmeleitpaste, zwischen Hochfrequenzbauteil und der Komponente hergestellt sein.

Gemäß einer vorteilhaften Ausgestaltung der Erfindung kann auf der dem Formteil zugewandten Seite der Platine mindestens ein Bauteil angeordnet sein, wobei das Bauteil durch eine Kavität in dem Formteil, deren Oberfläche bevorzugt metallisiert ist, abgedeckt ist.

Nebengeordnet umfasst die vorliegende Erfindung auch ein Verfahren zur Herstellung eines erfindungsgemäßen Radarsystems, bei dem das Formteil und die Platine während der Lötung (Lötprozess) und/oder Verklebung (Klebeprozess) zusammengepresst werden.

Das Zusammenpressen von Formteil und Platine wird dabei vorzugsweise durch temporär angebrachte Federelemente, wie z. B. Klammern und/oder Federstifte, oder durch in das Formteil integrierte federnde Elemente, welche mit der Platine vorzugsweise durch Einpressen oder Clipsen verbunden sind, realisiert.

Dadurch, dass Sollbiegestellen, beispielsweise in Form von Nuten, Durchbrüchen und/oder Stegen, vorgesehen sind, kann das Formteil in besonders einfacher Weise an die Platine angepresst werden.

### Kurzbeschreibung der Zeichnungen

Fig. 1 zeigt eine Hochfrequenzplatine eines Radarsystems nach Stand der Technik.
Fig. 2 zeigt die Oberseite (links) und die Unterseite (rechts) einer quaderförmigen kunststoffbasierten Hohlleiterantenne.
Fig. 3 zeigt einen Schnitt durch einen Radarsensor mit direkter Abstrahlung von einer Oberseite eines Hochfrequenzchips in eine Hohlleiterantenne.
Fig. 4 zeigt einen Schnitt durch einen Radarsensor mit direkter Abstrahlung von einer Unterseite eines Hochfrequenzchips durch Öffnungen in einer Platine in eine Hohlleiterantenne, welche sich auf der gegenüberliegenden Seite der Platine befindet.
Fig. 5 zeigt einen Schnitt durch den erfindungsgemäßen Radarsensor mit direkter Abstrahlung von einer Unterseite eines Hochfrequenzchips durch Öffnungen in einer Platine in eine Hohlleiterantenne, welche sich auf der gegenüberliegenden Seite der Platine befindet und welche durch ein einlagiges Formteil und die zumindest partiell metallisierte Platinenoberfläche selber gebildet wird, wobei Formteil und Platine zumindest partiell durch Lötung oder Klebung leitfähig verbunden sind.
In Fig. 6 ist das Formteil von seiner der Platine zugewandten Seite her dargestellt.
Fig. 7 zeigt eine temporäre Verbindung von Formteil und Platine während des Löt-oder Klebeprozesses durch einen Federstift.
In Fig. 8 ist ein in das Formteil integriertes Federelement zum Zusammenpressen von Formteil und Platine dargestellt.
Fig. 9 zeigt ein Formteil mit Sollbiegestellen, um ein Zusammenpressen von Formteil und Platine zu erleichtern.

### Ausführungsbeispiele

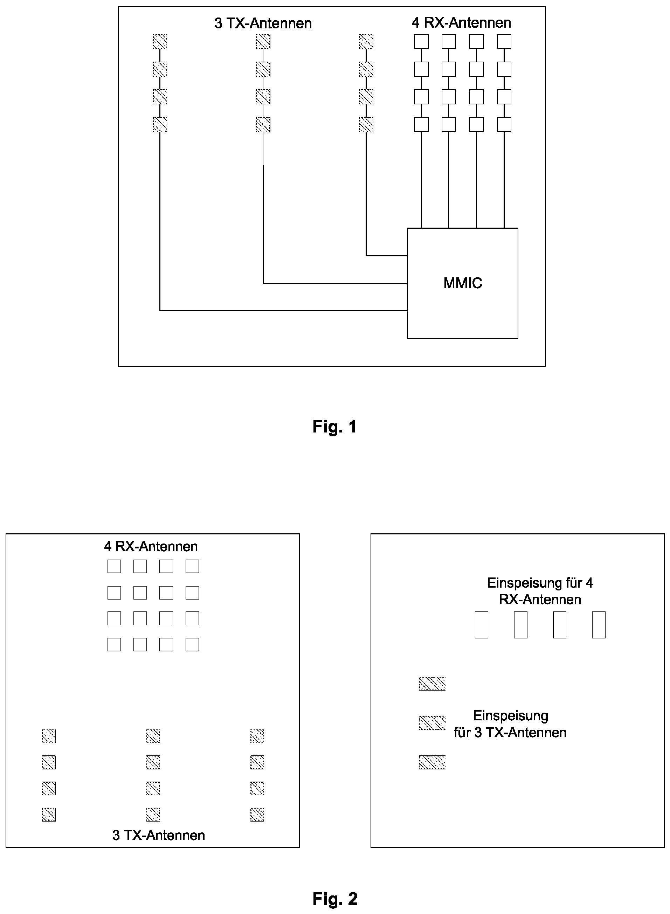

Heute werden Antennen für Radarsysteme zur Umfelderfassung meist als planare Antennen auf einer Hochfrequenzplatine realisiert. In Figur 1 ist eine Hochfrequenz-platine mit einem Hochfrequenzbauteil, einem sogenannten MMIC (Monolithic Microwave Integrated Circuit) und mit 3 Sendeantennen (TX) sowie 4 Empfangsantennen (RX) gezeigt, wobei die Antennen jeweils aus mehreren Einzelstrahlern zusammengesetzt sind. Die Antennen sind als planare Patchantennen realisiert.

Die Antennen und ihre Zuleitungen vom Hochfrequenzchip benötigen auf der Oberlage der Hochfrequenzplatine ein spezielles Substrat mit für Hochfrequenz geeigneten Materialdaten (z. B. definierte Dicke, definierte Dielektrizitätskonstante, sehr geringer Verlustwinkel). Insbesondere die Materialkosten dieses speziellen Substrats und seine Prozessierung (auch wegen der erforderlichen hohen Strukturgenauigkeiten) führen auf um Faktoren erhöhte Kosten gegenüber einer reinen Niederfrequenzplatine gleicher Größe und gleicher Lagenanzahl. Neben den Kosten sind aber auch die Signalverluste in den Antennen und ihren Zuleitungen nachteilig. Für eine Sende- und eine Empfangsantenne inkl. Zuleitungen liegt man zusammen typischerweise bei Leistungsverlusten von etwa 6dB. Eine derartig reduzierte Sensorempfindlichkeit resultiert in einer um 30% reduzierten maximalen Sensorreichweite.

Aufgrund der genannten Nachteile von platinenbasierten Antennen werden nun verstärkt sogenannte Wellenleiterantennen betrachtet. Hier werden Antennen und ihre Zuleitungen mit Hilfe von Hohlleitern realisiert, welche im einfachsten Fall rechteckförmige Hohlräume mit metallischen bzw. metallisierten Wänden darstellen; deshalb wird häufig auch die Bezeichnung Hohlleiterantenne verwendet. Eine solche Antenne kann als quaderförmiges Kunststoffteil ausgeführt sein und ist beispielsweise in Figur 2 dargestellt. Wie in Figur 2 gezeigt, gibt es auf der Oberseite Öffnungen zur Abstrahlung und auf der Unterseite Öffnungen zur Einspeisung; innerhalb des Kunststoffteils verlaufen Hohlraumstrukturen, wobei alle Oberflächen außen und innen metallisiert sind (für die eigentliche Funktionalität müssten nur die Oberflächen im Bereich der Hohlleiter und der Einzelantennen metallisiert sein, aus Gründen einer einfachen Fertigung wird meist aber die volle Oberfläche metallisiert); in Figur 2 nicht dargestellt sind Vertiefungen auf der Unterseite der Antenne für sich auf der darunterliegenden Platine befindliche Bauelemente (insbesondere den Hochfrequenzchip) und Hochfrequenzleitungen zu in die Hohlleiterantenne abstrahlenden Strukturen. Eine solche Antenne ist typischerweise aus wenigstens zwei metallisierten Lagen zusammengesetzt, um innenliegende Hohlleiter realisieren zu können; bei Verwendung von drei oder mehr Lagen ist auch ein Kreuzen von Hochfrequenzverbindungen möglich. Da die Anordnung der Einzelantennen nun unabhängig vom Chip ist, können, wie in Figur 2 dargestellt, die 3 Sendeantennen z. B. unterhalb der 4 Empfangsantennen angeordnet werden (bei der platinenbasierten Antenne nach Figur 1 sind sie nebeneinander angeordnet). Da der Chip nun nicht mehr auf der Antennenebene liegt, können kleinere Sensoren realisiert werden.

Als Herstellungsmethode für Kunststoffantennen kommt neben Spritzguss mittlerweile auch der 3D-Druck in Frage. Aus oberflächlich metallisiertem Kunststoff hergestellte Wellenleiterantennen haben gegenüber einer vollmetallischen Realisierung deutliche Herstellungs- und Kostenvorteile. Herausforderungen bei kunststoffbasierten Wellenleiterantennen sind die nötige Genauigkeit der Strukturen und die passgenaue Verbindung der mehreren Kunststofflagen - neue Herstellungsverfahren machen dies mittlerweile aber möglich.

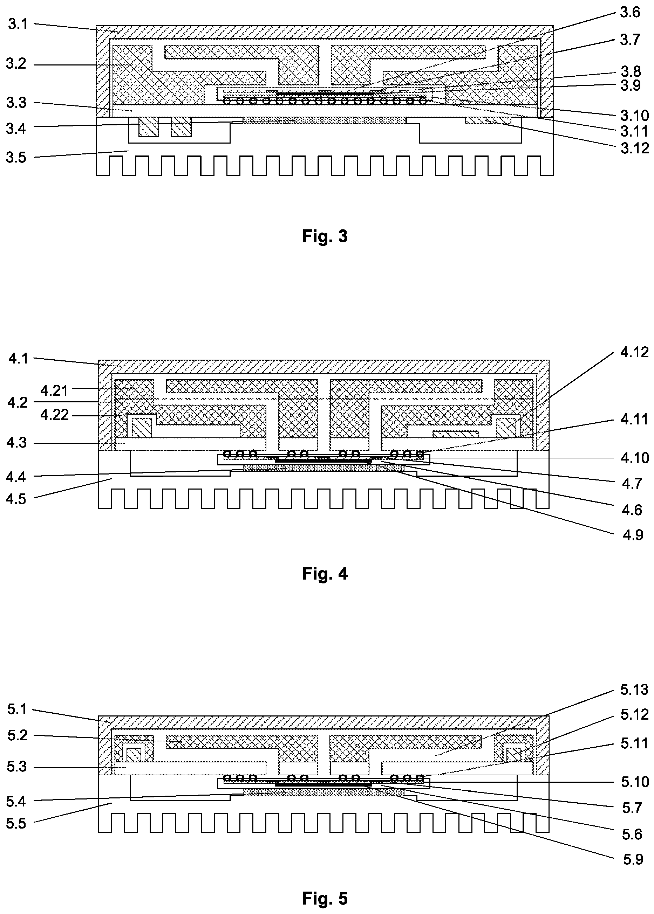

Aber auch bei der Verwendung von Kunststoffantennen hat man heute noch Hochfrequenzsignale auf der Platine, insbesondere jeweils vom Chipausgang bis zu einer in die Hohlleiterantenne abstrahlenden Struktur. Aufgrund dessen kommen auch hier vergleichsweise teure und aufwendige Platinen zum Einsatz. Aus diesem Grunde gibt es Bestrebungen direkt von der Oberseite des Hochfrequenzchips in die Hohleiterantenne abzustrahlen, wie in Figur 3 dargestellt. Dieser Ansatz weist allerdings einige Nachteile auf:
- toleranzkritisch ist der Übergang vom Chip 3.6 in die Wellenleiterantenne 3.2; in die lange Toleranzkette geht insbesondere Folgendes ein: Lötung vom Chip, Dicke vom Chip, Toleranzen der Antenne;
- direkter Kontakt der Antenne zum Chip (sowohl bei Produktion als auch über die Lebenszeit), wodurch der Chip geschädigt werden kann;
- Chip 3.6 benötigt neben dem Siliziumkern 3.9, welcher hochfrequente, niederfrequente und digitale Schaltkreise enthält, nicht nur unten einen sogenannten Redistributionlayer 3.10, sondern auch oben einen weiteren Redistributionlayer 3.8 für die Abstrahlelemente 3.7;
- Entwärmung vom Chip ist ungünstig, da Kunststoffantenne 3.2 und vorderes Kunststoffgehäuse 3.1 thermisch isolieren, so dass Wärme vom Chip fast ausschließlich nur über die Platine 3.3 abgeführt werden kann; die thermische Ankopplung des Chips an die metallische Sensorrückseite 3.5 über die Wärmeleitpaste 3.4 ist also nicht direkt, sondern nur durch die Platine hindurch möglich.

Zur Umgehung dieser Nachteile ist bereits in DE 102018203106 A1 der generelle Aufbau nach Figur 4 vorgeschlagen. Die abstrahlenden Elemente 4.7 sind nun auf der Unterseite des Chips 4.6 angeordnet, wobei sich der Chip 4.6 auf der zur Kunststoffantenne 4.2 gegenüberliegenden Seite der Platine 4.3 befindet. Vom Chip 4.6 wird die Kunststoffantenne 4.2 durch die Platine 4.3 gespeist, welche an diesen Stellen für die Radarwellen durchlässig ist; es werden also Hochfrequenz-Übergange vom Chip 4.6 in die Kunststoffantenne 4.2 durch die Platine 4.3 hindurch realisiert.

Wie im Figur 4 dargestellt, kann die Durchlässigkeit der Platine 4.3 jeweils einfach durch ein Loch in der Platine 4.3 realisiert werden, wobei die Seitenwände der Platine 4.3 an dieser Stelle dann metallisiert werden, so dass jeweils eine Art Hohlleiter realisiert wird.

Ein anderer in DE 102018203106 A1 vorgeschlagener Ansatz für durchlässige Übergänge in der Platine besteht darin, dort die Metallisierungen auf bzw. zwischen den Trägermaterialschichten der Platine wegzulassen und diese Bereiche mit Durchkontaktierungen zu umranden.

Um zu verhindern, dass an den Übergängen Strahlung in den Zwischenraum von Hochfrequenzbauteil und Platine entweicht, was einerseits zu Verlust an Leistung und andererseits zu Verkopplung zwischen den Übergängen führen würde, können um die Übergänge herum und damit zwischen den Übergängen Lotperlen (Balls) platziert werden. Dies ist beispielsweise in Figur 4 dargestellt, wo ein als sogenanntes Ball-Grid-Array ausgeführter Chip 4.6 mit Balls 4.11 gezeigt ist. Bei geeigneter Auslegung und Anordnung dieser Lotperlen 4.11 können sie eine Bandsperre für die verwendete Hochfrequenz darstellen und somit als EBG-Struktur (Electromagnetic Band-Gap) wirken.

Ein weiterer Vorteil der Anordnung nach Figur 4 besteht darin, dass sie eine gute thermische Kontaktierung des Chips 4.6, der eine hohe Stromaufnahme und damit Eigenerwärmung hat, erlaubt. Dazu wird der Chip 4.6 - wie dargestellt - über Wärmeleitpaste 4.4 an die sensorrückseitige Abdeckung 4.5, welche zumindest teilweise aus Aluminium bestehen und Kühlrippen besitzen kann, thermisch angekoppelt.

Wie in Figur 4 zudem dargestellt ist, können auf der der Kunststoffantenne 4.2 zugewandten Seite der Platine 4.3 Bauteile 4.12 bestückt werden, welche durch Kavitäten in der Kunststoffantenne 4.2 abgedeckt sind. Da die Oberfläche der Kunststoffantenne 4.2 ohnehin metallisiert ist, lässt sich so ohne Zusatzkosten eine elektrische Schirmung von Bauteilen realisieren.

In DE 102018203106 A1 wird nicht erläutert, wie die Kunststoffantenne mit der Platine verbunden wird. Wichtig ist insbesondere, dass im Bereich der Einspeisungen kein oder nur ein sehr kleiner Luftspalt (<50µm bei einem 77/79GHz-Radarsystem) zwischen Antenne 4.2 und Platine 4.3 besteht, da es ansonsten z. B. zur starken Verkopplung der verschiedenen Antennenkanäle und damit zu schlechter Winkelbildung und/oder reduzierter Sensorsensitivität kommt. Außerdem weist die in DE 102018203106 A1 beispielhaft gezeigte Antenne innenliegende Wellenleiterkanäle auf, d. h. sie muss aus wenigstens zwei Lagen zusammengesetzt sein - in der Antenne nach Figur 4 sind die zwei Lagen mit 4.21 und 4.22 bezeichnet. Zur Lösung bzw. Verbesserung dieser beiden Punkte wird die nachfolgende erfindungsgemäße Realisierung vorgeschlagen.

Figur 5 zeigt eine Wellenleiterantenne, die durch Löten oder leitfähiges Kleben eines metallischen oder zumindest partiell oberflächlich metallisierten einlagigen Formteils 5.2 auf die Platine 5.3 realisiert wird. Damit werden drei Seiten von innenliegenden Hohlleitern 5.13 durch das Formteil, die vierte Seite durch die dort oberflächlich metallisierte Platine realisiert. Etwas grob gesprochen wird die untere Antennenlage 4.22 aus Figur 4 nun durch die Platine 5.3 ersetzt; natürlich muss die Nut für den Wellenleiter im Formteil 5.2 nun die volle Tiefe des Wellenleiters haben. Vorteil ist, dass nur noch ein einlagiges Formteil benötigt wird, während die Antenne nach Figur 4 zwei Formteile erfordert hat; dies führt zu einer signifikanten Preisreduktion und zu reduzierter Baugröße. Der verwendete Verbindungsprozess, also Löten oder Verkleben, ist ebenfalls kostengünstig; im einfachsten Fall werden das Formteil und die Elektronikbauteile im selben Prozess aufgelötet, so dass kein zusätzlicher Prozessschritt nötig wird.

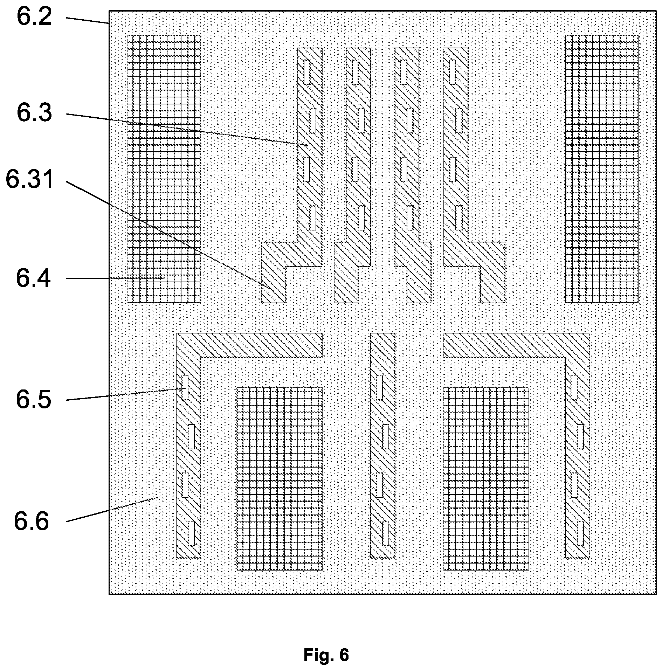

Während Figur 5 die Struktur des Formteils und insbesondere seine nach vorne abstrahlenden Elemente nur sehr vereinfacht und schematisch andeutet, zeigt Figur 6 die Struktur des Formteils 6.2 von der Rückseite her gesehen genauer. Die schraffierten Flächen sind Vertiefungen für Wellenleiter 6.3 (schrägschraffiert) und Bauteilekavitäten 6.4 (kariertschraffiert). Die weiß markierten Schlitze 6.5 sind Durchbrüche zur Oberseite, welche ihrerseits ansonsten unstrukturiert ist. Die gepunktete Fläche 6.6 stellt die ansonsten glatte Rückseite des Formteils dar. Am Anfang 6.31 der Wellenleiter findet die Einspeisung vom Hochfrequenzbauteil durch die Platine hindurch statt. Im Bereich der Einspeisung kann die Struktur im Formteil auch komplexer sein, um eine bessere Anpassung zu realisieren. Zur Auskopplung aus der Antenne können neben den gezeigten Schlitzen 6.5 auch andere Strukturen wie z. B. Hornstrahler zur Oberseite hin realisiert werden.

Die leitfähige Verbindung zwischen Formteil 6.2 und der darunterliegenden Platine sollte um die Wellenleiterstrukturen 6.3 herum bestehen. Statt vollflächiger Verbindung genügen auch einzelne Punkte (mit Abstand von typischerweise <1mm bei einem 77/79GHz-Radarsystem). Eine mögliche Ausführung dazu ist, dass das Formteil wie ein Chip mit Lotperlen (Balls) an der Unterseite ausgestattet ist und über diese mit der Platine verlötet wird.

Von Vorteil für die Verlötung oder Verklebung ist, wenn das Formteil auf der Rückseite möglichst eben ist (natürlich nur in den nicht vertieften Bereichen). Wird das Formteil aus Kunststoff im Spritzgussverfahren hergestellt, sind Thermoplaste als Basismaterial die fertigungstechnisch einfachste und günstigste Lösung - allerdings ist die mit Thermoplasten realisierbare Maßhaltigkeit und damit Ebenheit sowie ihr thermisches Ausdehnungsverhalten im Allgemeinen nicht optimal. Daneben sind Thermoplaste auch nicht besonders hitzebeständig, was beim Auflöten des Formteils auf die Platine dazu führen kann, dass ein Niedertemperaturlötprozess benötigt wird und damit die Lötung nicht im selben Prozessschritt wie die Elektronikbauteile (z. B. der Chip) stattfinden kann, d. h. es werden dann zwei separate Lötprozesse benötigt.

Diese Nachteile kann man durch Verwendung von Duroplasten als Kunststoffbasismaterial vermeiden; sie liefern maßhaltige und hitzebeständige Spritzgussformteile, die auch eine sehr glatte Oberfläche haben, was für möglichst verlustarme Wellenleiter wichtig ist (man benötigt zum "Glätten" der Oberflächen dann auch keine dicken Metallisierungsschichten, sondern es genügen dünne Metallisierungen, was Kosten einspart). Nachteil von Formteilen aus Duroplasten ist, dass ihre Herstellung im Allgemeinen etwas aufwändiger ist.

Neben durch Spritzguss hergestellten Kunststoffformteilen, deren Oberfläche metallisiert wird, kann man auch andere Herstellungsverfahren und Materialien benutzen; z. B. Herstellung mit 3D-Druck und/oder Verwendung von metallischen Basismaterialien (beispielsweise Aludruckguss gegebenenfalls mit nachträglicher Veredelung der Oberfläche).

Ist das verwendete Formteil maßhaltig, kann es ohne Anpressen an die Platine verlötet oder verklebt werden. Um eine laterale, also parallele Verschiebung des Formteils zur Platine zu vermeiden (also eine ausreichend genau laterale Positionierung zu gewährleisten), ist es vorteilhaft, wenn es auf der Unterseite des Formteils herausstehende Zapfen bzw. Stifte gibt, die in entsprechende Löcher der Platine hineinragen.

Bei weniger maßhaltigen Formteilen kann während des Löt- oder Klebevorgangs ein Anpressen der Antenne auf die Platine nötig sein, damit eine ausreichend gute Lötung um die Wellenleiterstrukturen 6.3 herum erzielt wird. Das kann durch Zusammendrücken über Stempel von oben und unten erfolgen.

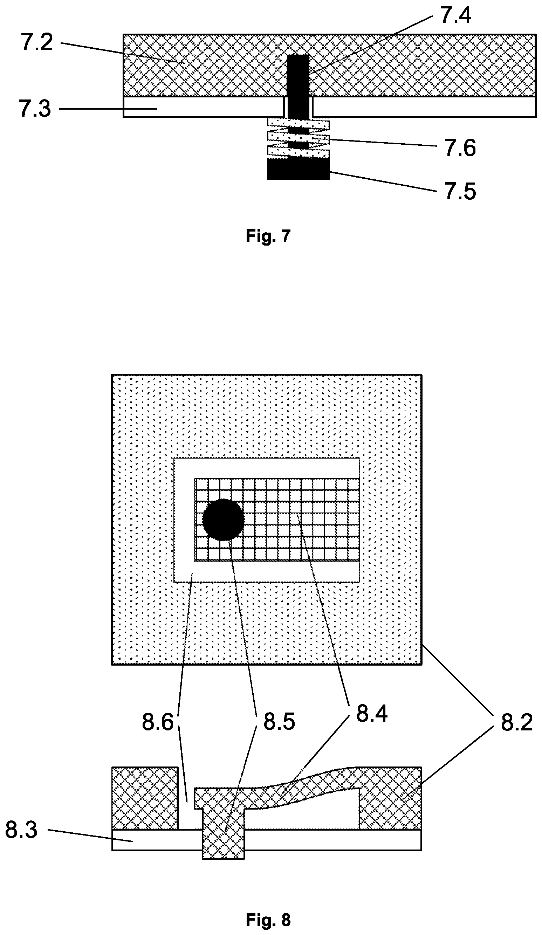

Alternativ kann es dadurch realisiert werden, dass vor dem Löt- oder Klebevorgang ein oder mehrere federnde Elemente zum Zusammenpressen von Formteil und Antenne angebracht und diese dann nach dem Löt- oder Klebevorgang wieder entfernt werden; neben Klammern können dabei auch Stifte mit einem Federelement eingesetzt werden, die von hinten durch ein Loch in der Platine in eine Presspassungsstruktur des Formteils eingedrückt werden, wobei ein federndes Element von hinten eine Kraft auf die Platine ausübt - eine beispielhafte Ausführungsform ist in Figur 7 dargestellt, wobei das federnde Element dort aus einer normalen Feder 7.6 besteht, die auf der einen Seite gegen den Kopf 7.5 des in das Formteil 7.2 gepressten Stifts 7.4 und auf der anderen Seite gegen die Platine 7.3 drückt, so dass die Platine und das Formteil zusammengedrückt werden (es ist in Figur 7 nur ein Ausschnitt der gesamten Anordnung dargestellt).

Statt temporär für den Löt- oder Klebeprozess separate federnde Element anzubringen, können diese auch als Element des Formteils selber realisiert werden. Figur 8 zeigt dafür ein Beispiel - oben ist ein Ausschnitt des Formteils 8.2 aus metallisiertem Kunststoff von hinten dargestellt, unten ein Schnitt durch Formteil 8.2 und Platine 8.3 in zusammengepresstem Zustand. Die durch eine an drei Seiten durchbrochene Kavität realisierte Struktur 8.4 trägt einen nach hinten herausragenden Zapfen 8.5, der in ein Loch der Platine 8.3 eingepresst ist; die Federwirkung wird durch die an drei Seiten freigeschnittene Struktur 8.4 und Verwendung von einem elastischen Kunststoff (z. B. aus Thermoplast) erzielt; die Durchbrüche zum Freischneiden der Struktur 8.4 sind mit 8.6 bezeichnet.

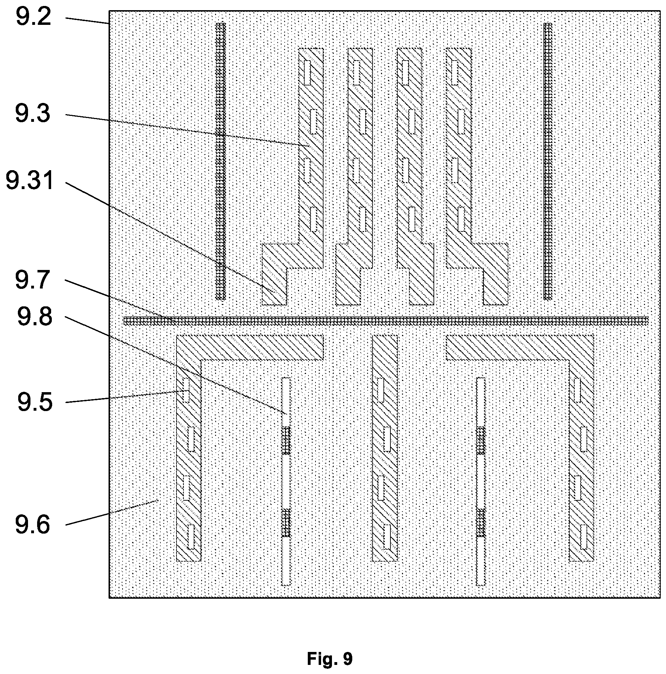

Das Zusammenpressen wird erleichtert, wenn das Formteil möglichst elastisch ist, was durch Sollbiegestellen wie in DE 102018213540 B3 vorgeschlagen erzielt werden kann. Wie in Figur 9 beispielhaft dargestellt, kann das Formteil dazu tiefe Nuten 9.7 und/oder Durchbrüche 9.8 aufweisen, so dass dünne, elastische Verbindungen bzw. Stege zwischen einzelnen Bereichen des Formteils realisiert werden; Nuten können von der Rück- und/oder Vorderseite her realisiert werden.

Bei Formteilen aus Kunststoff kann es hinsichtlich des Metallisierungsprozesses vorteilhaft sein, wenn die Vertiefungen für die Hohlleiter nicht gleichzeitig schmal und tief sind. Hohlleiter sind im einfachsten Fall rechteckförmig; deshalb ist es günstig, wenn die breite Seite des Hohlleiters parallel zur Rückseite liegt und die schmale Seite die Vertiefung darstellt bzw. definiert. Im Bereich der Einkopplung vom Chip her durch das Loch der Platine kann aber nicht genügend Platz für eine solche Orientierung eines rechteckförmigen Hohlleiters vorhanden sein, sofern die Einkoppelstellen nahe beieinander liegen (als Folge eines möglichst kleinen Chips). Dann werden platzsparende Übergangsstrukturen benötigt.

Kleine und wenig tiefe Hohlleiter können auch dadurch realisiert werden, dass ihr Querschnitt nicht rechteckförmig ist, sondern z. B. in der Mitte einer der langen Seiten einen längslaufenden erhöhten Steg aufweist; in der Fachsprache wird dies als "Ridged Waveguide" bezeichnet.

Bisher wurden einlagige Formteile betrachtet, da diese die kostengünstigste Variante darstellen. Für komplexe Antennen, die z. B. eine Kreuzung von Wellenleitern erfordern, wird mindestens eine weiter Lage benötigt. Vorzugsweise wird diese wenigstens eine weitere Lage als weiteres Formteil mit gleichem Fertigungsprozess wie das erste Formteil hergestellt, und die Verbindung dieses wenigstens einen weiteren Formteils mit dem ersten Formteil wird im selben Prozessschritt (insbesondere durch Löten oder leitfähiges Kleben) wie die Verbindung zwischen dem ersten Formteil und der Platine realisiert.

Abschließend sei noch Folgendes bemerkt:
Bei einem Radarsystem wird sowohl gesendet als auch empfangen. Vereinfachend wird in der obigen Beschreibung häufig nicht beides explizit ausgeführt bzw. unterschieden. Z. B. wird bei der Antenne oder den Elementen auf dem Chip von "(Ab)strahlen" gesprochen - bei Empfangsantennen bedeutet das natürlich "Empfangen"; und wenn beim Wellenleiter auf der Rückseite der Antenne von "Einspeisen" gesprochen wird, dann bedeutet das bei Empfangsantennen ein "Auskoppeln".

## Patentansprüche

1. Radarsystem zur Umgebungserfassung aufweisend
- eine Platine (5.3, 7.3, 8.3), welche mindestens ein Hochfrequenzbauteil (5.6) mit mindestens einem Element (5.7) zum direkten Abstrahlen bzw. Empfangen trägt, und
- ein Formteil (5.2, 6.2, 7.2, 8.2, 9.2), welches an seiner Oberseite eine oder mehrere Einzelantennen zum Senden und/oder Empfangen von Radarsignalen aufweist,
- wobei die Verbindung zwischen dem mindestens einen abstrahlenden bzw. empfangenden Element (5.7) des Hochfrequenzbauteils (5.6) und der mindestens einen Einzelantenne auf der Oberseite des Formteils (5.2, 6.2, 7.2, 8.2, 9.2) zumindest teilweise durch innenliegende Wellenleiter realisiert wird, wobei
- das mindestens eine abstrahlende bzw. empfangende Element (5.7) des Hochfrequenzbauteils (5.6) derart ausgebildet ist, dass es in Richtung Platine (5.3, 7.3, 8.3) abstrahlt bzw. aus Richtung Platine (5.3) empfängt,
- die Platine (5.3, 7.3, 8.3) im Bereich des mindestens einen abstrahlenden bzw. empfangenden Elements (5.7) für Radarwellen durchlässig ist,
- das Formteil (5.2, 6.2, 7.2, 8.2, 9.2) auf der zu dem wenigstens einen Hochfrequenzbauteil (5.6) gegenüberliegenden Seite der Platine (5.3, 7.3, 8.3) angeordnet und mit dieser zumindest partiell und leitfähig verbunden ist,
wobei
- wenigstens ein hohlförmiger Wellenleiter (5.13) durch eine Vertiefung auf der der Platine zugewandten Seite des Formteils (5.2, 6.2, 7.2, 8.2, 9.2) und eine metallisierte Oberfläche von der zu dem wenigstens einen Hochfrequenzbauteil (5.6) gegenüberliegenden Seite der Platine (5.3, 7.3, 8.3) gebildet wird, und
- dieser wenigstens eine Wellenleiter (5.13) aus einer durchlässigen Stelle der Platine (5.3, 7.3, 8.3) gespeist wird.

2. Radarsystem nach einem der vorangehenden Ansprüche, **dadurch gekennzeichnet, dass** das Formteil (5.2, 6.2, 7.2, 8.2, 9.2) Sollbiegestellen aufweist durch die es an die Platine angeordnet oder angepresst werden kann.

3. Radarsystem nach einem der vorangehenden Ansprüche, **dadurch gekennzeichnet, dass** sich auf der der Platine (5.3, 7.3, 8.3) zugewandten Seite des Formteils (5.2, 7.2, 8.2) Lotperlen (5.11) befinden, die zur Verlötung dienen und einen Teil der Wellenleiterberandung darstellen.

4. Radarsystem nach einem der vorangehenden Ansprüche, **dadurch gekennzeichnet, dass** die Positionierung des Formteils (5.2, 6.2, 7.2, 8.2, 9.2) parallel zur Platine (5.3, 7.3, 8.3) durch Strukturen realisiert wird, die vom Formteil (5.2, 6.2, 7.2, 8.2, 9.2) in Aussparungen oder Löcher der Platine (5.3, 7.3, 8.3) ragen.

5. Radarsystem nach einem der vorangehenden Ansprüche, **dadurch gekennzeichnet, dass** die mindestens eine für Radarwellen durchlässige Stelle der Platine (5.3, 7.3, 8.3) durch ein Loch in der Platine (5.3, 7.3, 8.3) mit metallisierten Seitenwänden ausgebildet ist.

6. Radarsystem nach einem der Ansprüche 1 bis 4, **dadurch gekennzeichnet, dass** die mindestens eine für Radarwellen durchlässige Stelle in der Platine (5.3, 7.3, 8.3) dadurch realisiert ist, dass sich dort auf und/oder zwischen Trägermaterialschichten der Platine (5.3, 7.3, 8.3) keine Metallisierung befindet und die Stelle mit Durchkontaktierungen umrandet ist.

7. Radarsystem nach einem der vorangehenden Ansprüche, **dadurch gekennzeichnet, dass** auf der Unterseite des mindestens einen Hochfrequenzbauteils (5.6) Lotperlen (5.11) um das mindestens eine abstrahlende bzw. empfangende Element (5.7) derart angeordnet sind, dass ein seitliches Entweichen der Strahlung in einem Zwischenraum von Hochfrequenzbauteil (5.6) und Platine (5.3) reduziert bzw. verhindert wird.

8. Radarsystem nach einem der vorangehenden Ansprüche, **gekennzeichnet durch** eine thermisch gut leitende Komponente, wobei die Komponente auf derselben Seite der Platine (5.3) wie das mindestens eine Hochfrequenzbauteil (5.6) angeordnet ist, und ein thermischer Kontakt zwischen Hochfrequenzbauteil (5.6) und der Komponente hergestellt ist.

9. Radarsystem nach Anspruch 8, **dadurch gekennzeichnet, dass** als thermisch gut leitende Komponente ein Deckel (5.5) aus Metall vorgesehen ist und der thermische Kontakt zwischen Hochfrequenzbauteil (5.6) und Deckel (5.5) durch Wärmeleitpaste (5.4) hergestellt ist.

10. Radarsystem nach einem der vorangehenden Ansprüche, **dadurch gekennzeichnet, dass** auf der dem Formteil (5.2) zugewandten Seite der Platine (5.3) mindestens ein Bauteil (5.12) angeordnet ist, wobei das Bauteil (5.12) durch eine Kavität in dem Formteil (5.2) abgedeckt ist.

11. Radarsystem nach Anspruch 10, **dadurch gekennzeichnet, dass** die Oberfläche der Kavität in dem Formteil (5.2) metallisiert ist.

12. Verfahren zur Herstellung eines Radarsystems nach einem der vorhergehenden Ansprüche, wobei das Formteil (5.2, 6.2, 7.2, 8.2, 9.2) mit der Platine (5.3, 7.3, 8.3) durch Lötung und/oder leitfähige Verklebung zumindest partiell und leitfähig verbunden ist, bei dem das Formteil (5.2, 6.2, 7.2, 8.2, 9.2) und die Platine (5.3, 7.3, 8.3) während der Lötung und/oder der Verklebung zusammengepresst werden.

13. Verfahren nach Anspruch 12, **dadurch gekennzeichnet, dass** das Zusammenpressen von Formteil (5.2, 7.2, 8.2) und Platine (5.3, 7.3, 8.3) durch temporär angebrachte Federelemente (7.6) oder durch in das Formteil (8.2) integrierte federnde Elemente (8.4, 8.5, 8.6) realisiert wird.

14. Verfahren nach Anspruch 13, **dadurch gekennzeichnet, dass** die in das Formteil (8.2) integrierten federnden Elemente mit der Platine (8.3) durch Einpressen oder Clipsen verbunden sind.

15. Verfahren nach einem der Ansprüche 12-14, **dadurch gekennzeichnet, dass** das Formteil (9.2) durch Sollbiegestellen an die Platine angepresst wird.

## Claims

1. A radar system for detecting surroundings, comprising
- a circuit board (5.3, 7.3, 8.3), which carries at least one high-frequency component (5.6) having at least one element (5.7) for directly emitting or receiving, and
- a molded part (5.2, 6.2, 7.2, 8.2, 9.2), which comprises one or more individual antennas for emitting and/or receiving radar signals on its upper side,
- wherein the connection between the at least one emitting or receiving element (5.7) of the high-frequency component (5.6) and the at least one individual antenna on the upper side of the molded part (5.2, 6.2, 7.2, 8.2, 9.2) is at least partially implemented by internal waveguides, wherein
- the at least one emitting or receiving element (5.7) of the high-frequency component (5.6) is designed such that it emits in the direction of the circuit board (5.3, 7.3, 8.3) or receives from the direction of the circuit board (5.3),
- the circuit board (5.3, 7.3, 8.3) is transmissive for radar waves in the area of the at least one emitting or receiving element (5.7),
- the molded part (5.2, 6.2, 7.2, 8.2, 9.2) is arranged on the side of the circuit board (5.3, 7.3, 8.3) opposite to the at least one high-frequency component (5.6) and is connected thereto at least partially and conductively,
wherein
- at least one hollow waveguide (5.13) is formed by a depression on the side of the molded part (5.2, 6.2, 7.2, 8.2, 9.2) facing toward the circuit board and a metallized surface of the side of the circuit board (5.3, 7.3, 8.3) opposite to the at least one high-frequency component (5.6), and
- this at least one waveguide (5.13) is fed from a transmissive point of the circuit board (5.3, 7.3, 8.3).

2. The radar system as claimed in any one of the preceding claims, **characterized in that** the molded part (5.2, 6.2, 7.2, 8.2, 9.2) comprises intended bending points, by which it can be arranged or pressed on the circuit board.

3. The radar system as claimed in any one of the preceding claims, **characterized in that** solder beads (5.11), which are used for soldering and represent a part of the waveguide border, are located on the side of the molded part (5.2, 7.2, 8.2) facing toward the circuit board (5.3, 7.3, 8.3).

4. The radar system as claimed in any one of the preceding claims, **characterized in that** the positioning of the molded part (5.2, 6.2, 7.2, 8.2, 9.2) parallel to the circuit board (5.3, 7.3, 8.3) is implemented by structures which protrude from the molded part (5.2, 6.2, 7.2, 8.2, 9.2) into recesses or holes of the circuit board (5.3, 7.3, 8.3).

5. The radar system as claimed in any one of the preceding claims, **characterized in that** the at least one point of the circuit board (5.3, 7.3, 8.3) transmissive for radar waves is formed by a hole in the circuit board (5.3, 7.3, 8.3) having metallized side walls.

6. The radar system as claimed in any one of claims 1 to 4, **characterized in that** the at least one point in the circuit board (5.3, 7.3, 8.3) transmissive for radar waves is implemented **in that** no metallization is located there on and/or between carrier material layers of the circuit board (5.3, 7.3, 8.3) and the point is bordered by three contacts.

7. The radar system as claimed in any one of the preceding claims, **characterized in that** solder beads (5.11) are arranged on the lower side of the at least one high-frequency component (5.6) around the at least one emitting or receiving element (5.7) such that a lateral escape of the radiation into an intermediate space of high-frequency component (5.6) and circuit board (5.3) is reduced or prevented.

8. The radar system as claimed in any one of the preceding claims, **characterized by** a component having good thermal conductivity, wherein the component is arranged on the same side of the circuit board (5.3) as the at least one high-frequency component (5.6), and a thermal contact is established between high-frequency component (5.6) and the component.

9. The radar system as claimed in claim 8, **characterized in that** a cover (5.5) made of metal is provided as the component having good thermal conductivity and the thermal contact between high-frequency component (5.6) and cover (5.5) is established by heat conductive paste (5.4).

10. The radar system as claimed in any one of the preceding claims, **characterized in that** at least one component part (5.12) is arranged on the side of the circuit board (5.3) facing toward the molded part (5.2), wherein the component part (5.12) is covered by a cavity in the molded part (5.2).

11. The radar system as claimed in claim 10, **characterized in that** the surface of the cavity in the molded part (5.2) is metallized.

12. A method for producing a radar system as claimed in any one of the preceding claims, wherein the molded part (5.2, 6.2, 7.2, 8.2, 9.2) is at least partially and conductively connected to the circuit board (5.3, 7.3, 8.3) by soldering and/or conductive adhesive bonding, in which the molded part (5.2, 6.2, 7.2, 8.2, 9.2) and the circuit board (5.3, 7.3, 8.3) are pressed together during the soldering and/or the adhesive bonding.

13. The method as claimed in claim 12, **characterized in that** the pressing together of molded part (5.2, 7.2, 8.2) and circuit board (5.3, 7.3, 8.3) is implemented by temporarily attached spring element (7.6) or by springy elements (8.4, 8.5, 8.6) integrated in the molded part (8.2).

14. The method as claimed in claim 13, **characterized in that** the springy elements integrated in the molded part (8.2) are connected to the circuit board (8.3) by pressing and or clipping.

15. The method as claimed in any one of claims 12 to 14, **characterized in that** the molded part (9.2) is pressed onto the circuit board by intended bending points.

## Revendications

1. Système radar pour la détection d'un environnement, comprenant
- une platine (5.3, 7.3, 8.3) qui porte au moins un composant haute fréquence (5.6) avec au moins un élément émetteur et récepteur (5.7) pour l'émission ou la réception directe, et
- une pièce moulée (5.2, 6.2, 7.2, 8.2, 9.2) qui comprend, sur sa face supérieure, une ou plusieurs antennes individuelles pour émettre et/ou recevoir des signaux radar,
- la liaison entre ledit au moins un élément émetteur et récepteur (5.7) du composant haute fréquence (5.6) et ladite au moins une antenne individuelle sur la face supérieure de la pièce moulée (5.2, 6.2, 7.2, 8.2, 9.2) étant réalisée au moins en partie par des guides d'ondes internes,
- ledit au moins un élément émetteur et récepteur (5.7) du composant haute fréquence (5.6) est conçu de telle sorte qu'il émet en direction de la platine (5.3, 7.3, 8.3) ou qu'il reçoit depuis la platine (5.3),
- la platine (5.3, 7.3, 8.3) est perméable aux ondes radar dans la zone dudit au moins un élément émetteur et récepteur (5.7),
- la pièce moulée (5.2, 6.2, 7.2, 8.2, 9.2) est agencée sur le côté de la platine (5.3, 7.3, 8.3) opposé audit au moins un composant haute fréquence (5.6) et est reliée à celle-ci au moins partiellement et de manière conductrice,
- au moins un guide d'ondes creux (5.13) est formé par un renfoncement sur le côté de la pièce moulée (5.2, 6.2, 7.2, 8.2, 9.2) tourné vers la platine et par une surface métallisée du côté de la platine (5.3, 7.3, 8.3) opposé audit au moins un composant haute fréquence (5.6), et
- cet au moins un guide d'ondes (5.13) est alimenté à partir d'un emplacement perméable de la platine (5.3, 7.3, 8.3).

2. Système radar selon l'une des revendications précédentes, **caractérisé en ce que** la pièce moulée (5.2, 6.2, 7.2, 8.2, 9.2) présente des points de flexion prédéterminés grâce auxquels elle est apte à être agencée ou pressée contre la platine.

3. Système radar selon l'une des revendications précédentes, **caractérisé en ce que**, sur le côté de la pièce moulée (5.2, 7.2, 8.2) tourné vers la platine (5.3, 7.3, 8.3), se trouvent des perles de soudure (5.11) qui servent au soudage et qui constituent une partie de la bordure du guide d'ondes.

4. Système radar selon l'une des revendications précédentes, **caractérisé en ce que** le positionnement de la pièce moulée (5.2, 6.2, 7.2, 8.2, 9.2) parallèlement à la platine (5.3, 7.3, 8.3) est réalisé par des structures qui font saillie de la pièce moulée (5.2, 6.2, 7.2, 8.2, 9.2) dans des évidements ou des trous de la platine (5.3, 7.3, 8.3).

5. Système radar selon l'une des revendications précédentes, **caractérisé en ce que** ledit au moins un emplacement de la platine (5.3, 7.3, 8.3) perméable aux ondes radar est formé par un trou dans la platine (5.3, 7.3, 8.3) ayant des parois latérales métallisées.

6. Système radar selon l'une des revendications 1 à 4, **caractérisé en ce que** ledit au moins un emplacement perméable aux ondes radar dans la platine (5.3, 7.3, 8.3) est réalisé de telle sorte qu'il n'y a pas de métallisation à cet endroit sur et/ou entre les couches de matériau support de la platine (5.3, 7.3, 8.3) et **en ce que** l'emplacement est entouré de contacts traversants.

7. Système radar selon l'une des revendications précédentes, **caractérisé en ce que**, sur la face inférieure dudit au moins un composant haute fréquence (5.6), des perles de soudure (5.11) sont agencées autour dudit au moins un élément émetteur et récepteur (5.7) de telle sorte qu'une fuite latérale du rayonnement dans un espace intermédiaire entre le composant haute fréquence (5.6) et la platine (5.3) est réduite ou empêchée.

8. Système radar selon l'une des revendications précédentes, **caractérisé par** un composant thermoconducteur, le composant étant agencé sur le même côté de la platine (5.3) que le composant haute fréquence (5.6) et un contact thermique étant établi entre le composant haute fréquence (5.6) et le composant.

9. Système radar selon la revendication 8, **caractérisé en ce qu'**un couvercle (5.5) en métal est prévu en tant que composant thermiquement conducteur et **en ce que** le contact thermique entre le composant haute fréquence (5.6) et le couvercle (5.5) est établi par une pâte (5.4) thermoconductrice.

10. Système radar selon l'une des revendications précédentes, **caractérisé en ce qu'**au moins un composant (5.12) est agencé sur le côté de la platine (5.3) tourné vers la pièce moulée (5.2), le composant (5.12) étant recouvert par une cavité aménagée dans la pièce moulée (5.2).

11. Système radar selon la revendication 10, **caractérisé en ce que** la surface de la cavité dans la pièce moulée (5.2) est métallisée.

12. Procédé de fabrication d'un système radar selon l'une des revendications précédentes, dans lequel la pièce moulée (5.2, 6.2, 7.2, 8.2, 9.2) est reliée au moins partiellement à la platine (5.3, 7.3, 8.3) et de manière conductrice par soudure et/ou collage conducteur, la pièce moulée (5.2, 6.2, 7.2, 8.2, 9.2) et la platine (5.3, 7.3, 8.3) étant pressées l'une contre l'autre pendant le soudage et/ou le collage.

13. Procédé selon la revendication 12, **caractérisé en ce que** le pressage de la pièce moulée (5.2, 7.2, 8.2) et de la platine (5.3, 7.3, 8.3) est réalisé par des éléments élastiques (7.6) montés temporairement ou par des éléments élastiques (8.4, 8.5, 8.6) intégrés dans la pièce moulée (8.2).

14. Procédé selon la revendication 13, **caractérisé en ce que** les éléments élastiques intégrés dans la pièce moulée (8.2) sont reliés à la platine (8.3) par emmanchement ou clipsage.

15. Procédé selon l'une des revendications 12 à 14, **caractérisé en ce que** la pièce moulée (9.2) est pressée contre la platine par des points de flexion prédéterminés.
